# EUROPEAN PATENT APPLICATION

(11) **EP 1 020 919 A2**
(43) Date of publication of application: **19.07.2000**
(21) Application number: 00300056.9
(22) Date of filing: 06.01.2000
(51) Int. Cl.: H01L 27/108, H01L 21/8242

(54) **Stacked capacitor DRAM cell**

(30) Priority: 12.01.1999 US 115701 P; 01.07.1999 US 345919
(71) Applicant: LUCENT TECHNOLOGIES INC., Murray Hill, New Jersey 07974-0636 (US)
(72) Inventor: Seungmoo, Choi, Orlando Florida 32835 (US)
(74) Representative: Watts, Christopher Malcolm Kelway, Dr.

(57) **Abstract**

A DRAM cell is provided that has a reduced area while maintaining capacitance. The MOSFET is conventionally formed in and on a semiconductor substrate and the storage capacitor (e.g., 205a, 205b) for different DRAM cells are formed in different layers (e.g., 210, 240) of an integrated circuit. As a result, the storage capacitors may be overlapped reducing cell size.

## Description

### Field of the Invention

The present invention relates to integrated circuits and, more particularly, to dynamic random access memory (DRAM) fabrication and devices.

### Background of the Invention

Dynamic random access memory (DRAM) relates to electronic devices consisting of cells which can retain information only for a limited time before they must be read and refreshed at periodic intervals. Typically, a DRAM storage cell comprises a transistor and a capacitor wherein the gate of the transistor is controlled by a word line signal, and data represented by the logic level of the storage capacitor is written into or read out of the capacitor through a bit line signal.

In general, the integrated circuit used for DRAMs consists of metal oxide semiconductor (MOS) and particularly complementary MOS structures (CMOS) as the transistor component. Recently, the capacity of such DRAM structures has evoked from one megabit to on the order of one gigabit. This increase in memory has required the evolution of gate feature sizes on the order of 1.25 microns down to on the order of 0.25 microns or smaller. As the DRAM capacity requirements are increased, the requirements placed on the capacitors are increased as well. Not only is there a requirement for increased capacitance, there is also a requirement for decreased capacitor area. Accordingly, development efforts have been focused on materials and structures to meet this need.

To minimize interconnection resistance and to maximize the use of valuable chip area, advanced VLSI and ULSI logic integrated semiconductor circuits use multi-level wiring line structures for interconnecting regions within the devices and for interconnecting one or more devices within the integrated circuit. Multi-level metallization provides greater flexibility in circuit design, a reduction in die size and, thereby, a reduction in chip cost. In fabricating such structures, the conventional approach is to form lower level wiring lines (or interconnect structures) and then form one or more upper level wiring lines interconnected with the first level wiring lines. A first level interconnect structure may be in contact with the doped region within the substrate of an integrated circuit device (for example the source or drain of a typical MOSFET). One or more interconnections are typically formed between the first level interconnect and other portions of the integrated circuit device or to structures external to the integrated circuit device. This is accomplished through the second and subsequent levels of wiring lines.

One recent design and fabrication process for a DRAM cell is set forth in U.S. Patent 5,792,960, incorporated herein by reference, wherein a polysilicon DRAM capacitor is vertically aligned with a polysilicon transistor gate structure while using an underlying bit line embedded in the device isolation insulator. Still other methods for fabricating DRAM capacitors and DRAM cells can be found with reference to U.S. Patents 5,482,886; 5,648,290; 5,677,222; and 5,792,690, all of which are incorporated herein by reference.

Generally, it is desirable to fabricate a DRAM cell having a high capacitance capacitor in order to maintain a high signal to noise ratio in reading the memory cell and to reduce soft errors (due to alpha particle interference). However, it is also desirable to achieve small feature size and to utilize a cost effective fabrication process. Since, for any given dielectric, the greater the capacitor area the greater the capacitance, one may compromise capacitance and cell size. Hence, it is desirable to reduce cell size without reducing capacitance.

### Summary of the Invention

The present invention is directed to a DRAM cell that has a reduced area while maintaining capacitance. The MOSFET is conventionally formed in and on a semiconductor substrate and the storage capacitor for different DRAM cells are formed in different layers of the IC. As a result, the storage capacitors may be overlapped reducing cell size.

### Brief Description of the Drawings

The invention is best understood from the following detailed description when read in connection with the accompanying drawing. It is emphasized that, according to common practice in the semiconductor industry, the various features of the drawing are not to scale. On the contrary, the dimensions of the various features are arbitrarily expanded or reduced for clarity. Included in the drawing are the following figures:
Fig. 1 is a flowchart diagram illustrating the process for manufacturing DRAM cells according to an exemplary embodiment of the present invention;
Figs. 2-5 are cross sectional views representing the sequence of steps involved in the method of forming DRAM cells including overlapping storage capacitors; and
Fig. 6 is a cross sectional view of an alternative embodiment of the present invention.

### Detailed Description of the Preferred Embodiment

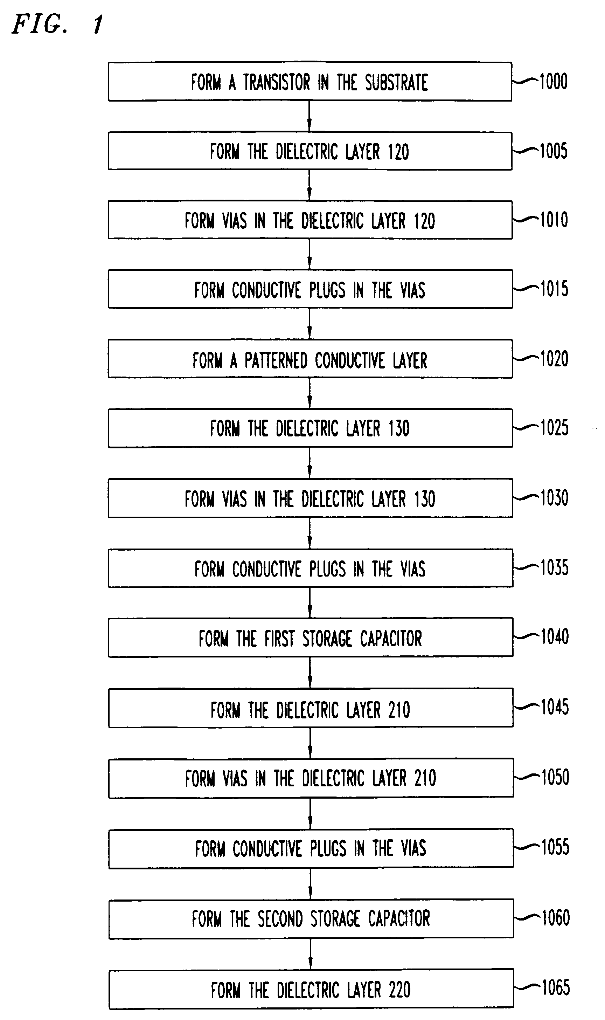

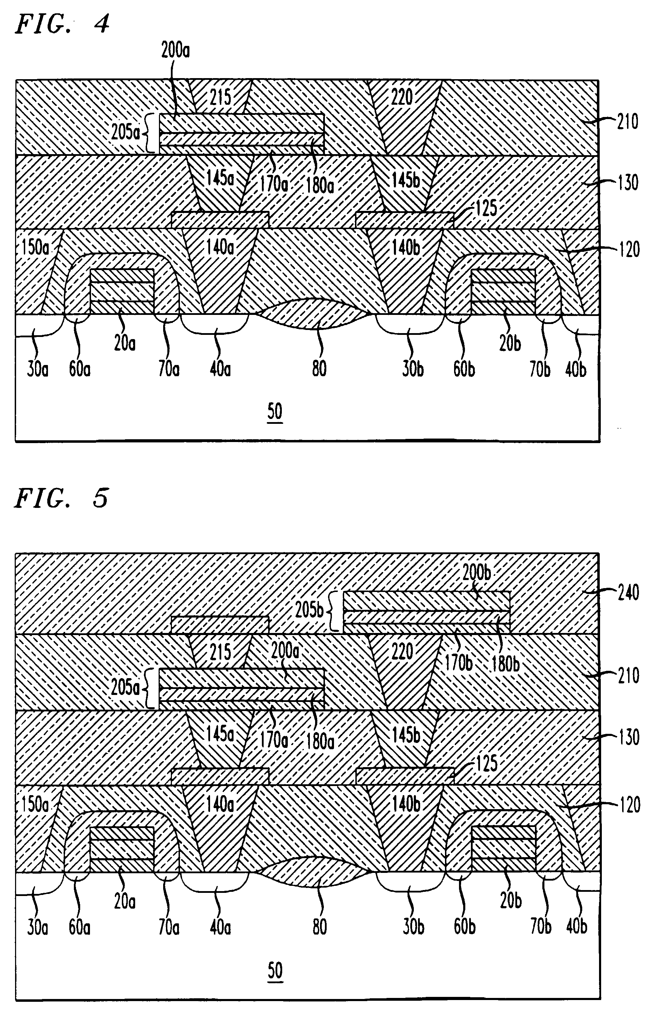

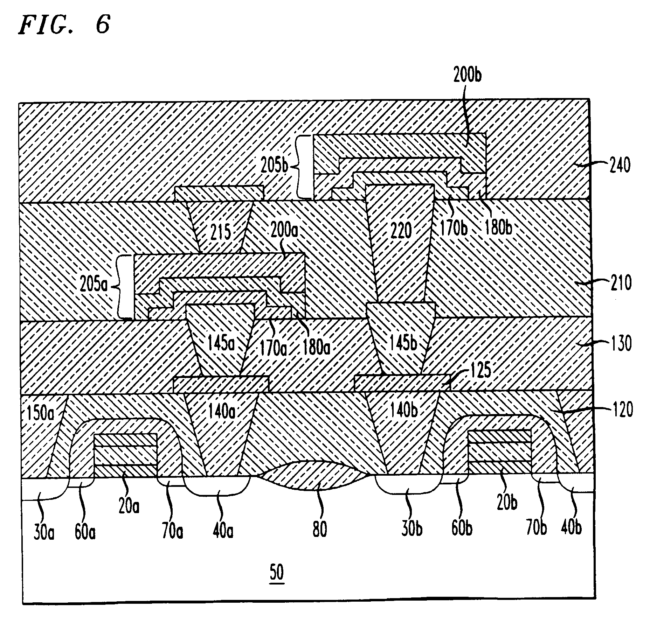

Briefly, as is shown in Figs. 5 and 6, the present invention is directed towards a DRAM cell including a transistor and a storage capacitor. The storage capacitors 205a, 205b for at least two different DRAM cells are formed in non-coplanar relationship with each other. For example, the storage capacitors may be formed in different layers of the integrated circuit. Further, the storage capacitors 205a, 205b of adjacent DRAM cells may be positioned so that they overlap each other. In addition, the storage capacitors may be electrically coupled to a plug (an electrical interconnect between layers of the IC) and positioned asymmetrically about that plug to increase the overlap with an adjacent DRAM cell. As a result, DRAM cells may be positioned closer together without decreasing the capacitance of the storage capacitor. In other words, the DRAM cell area is decreased. The process for manufacturing the DRAM cells shown in Figs. 5 and 6 is described below with reference to Figs. 1 to 5.

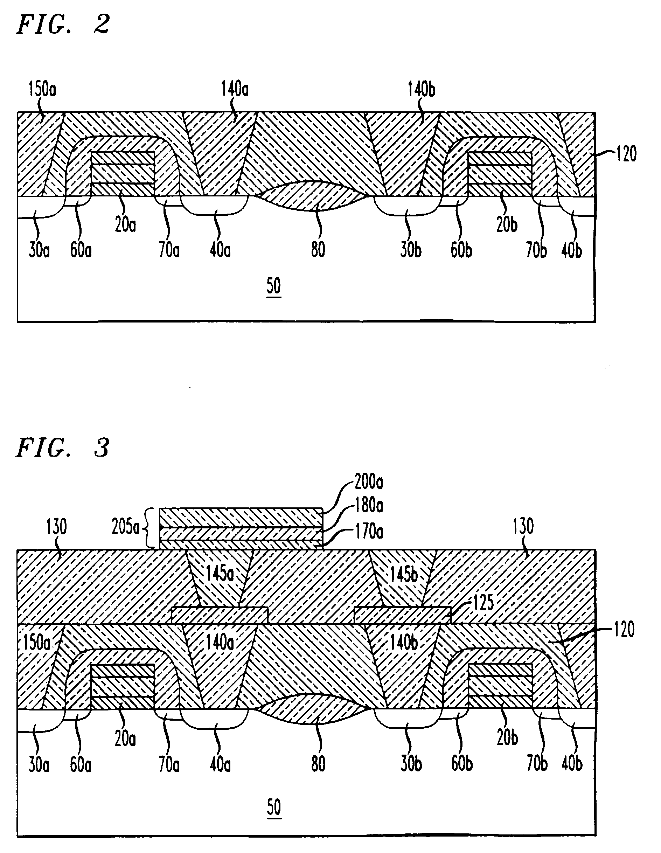

Figs. 2-5 are cross-sectional views illustrating the sequence to form adjacent DRAM cells. At step 1000, shown in Fig.1, a transistor is formed in a substrate 50. As is shown in Figure 2, a typical DRAM cell transistor may be an n-type MOSFET that includes gate electrodes 20a, 20b and n⁺ source regions 30a, 30b and n⁺ drain regions 40a, 40b formed in a silicon substrate 50. The source and drain regions 30a, 30b and 40a, 40b are generally separated from the gates 20a, 20b by lightly doped n regions 60a, 60b and 70a, 70b, respectively. A field oxide 80 is also provided. The formation of the transistor for use in DRAM cells and integrated semiconductor processing and memory devices is well known in the art. For example, reference can be made to U.S. Patent 5,648,290, incorporated herein by reference, which sets forth a process for forming such transistors.

Next at step 1005, a conformal dielectric layer 120 is formed over the surface of the transistors. Next at step 1010, vias are opened in the dielectric layer 120 using conventional lithography and etching techniques. Then, at step 1015, conductive plugs 140a, 140b are formed in the vias using the process described below. The conductive plugs 140a, 140b include a barrier layer of titanium formed on titanium nitride and tungsten formed on the barrier layer. After the barrier layer and the tungsten are blanket deposited, they are polished using chemical mechanical polishing to remove the material formed on the upper surface of the dielectric layer 120 and to planarize. The plugs 140a, 140b provide electrical connections through the conformal dielectric layer 120 of the cell to the sources 30a 30b and the drain 40a ,40b.

Each of the plugs includes a barrier layer. The plugs 140a, 150a, 140b, 145a, 145b, 215, 220 may be made of the same material(s). TiN may be used as a barrier layer for plugs including tungsten and TaN may be used as a barrier for plugs including copper. Preferable, plugs 140a, 150a, 140b may be tungsten instead of copper to avoid potential contamination.

At step 1020 (Fig. 3), a patterned conductive layer 125 is formed on the dielectric layer 120. The patterned conductive layer 125 is, for example, a metal such as aluminum or tungsten or copper. At step 1025, a planarized top dielectric layer 130 is formed over the patterned conductive layer 125 and the dielectric layer 120. The dielectric layer 130 may be deposited using conventional techniques and planarized using chemical mechanical polishing (CMP).

Typically, the gate electrodes 20a, 20b are polysilicon or polycide, the conformal dielectric layer 120 is a high-density deposited silicon oxide, and the top dielectric layer 130 is a chemical vapor deposited (CVD) silicon oxide layer. However, both dielectric layers 120 and 130 can be high-density plasma silicon oxides. In current processing techniques, high-density plasma silicon oxide is the most common choice for the back end dielectrics. This is because the high-density silicon oxide seems to offer the best results with respect to filling of narrow gaps and can be deposited at low temperature compared with CVD processing. Alternatively, dielectrics 120 and 130 may be a borophosphosilicate glass, a phosphosilicate glass, a glass formed from phosphorous and/or boron-doped tetraethyl orthosilicate, spin-on glass or other low dielectric constant films such as polymer, fluorinated oxide and hydrogen silsesquioxane.

At step 1030, vias are opened in the dielectric layer 130 using conventional lithography and etching techniques. Then, at step 1035, conductive plugs 145a, 145b are formed in the vias using the process described above with regard to plugs 140a, 140b. The plugs 145a, 145b electrically couple subsequent layers with the plugs 140a, 140b.

At step 1040, a storage capacitor 205a is formed. First, a conductive electrode layer 170a; preferably of a high work function material, is formed over the dielectric layer 130 to form the bottom plate of the storage capacitor 205a. A high dielectric film 180a is then deposited over the conductive layer 170a.

While the term high dielectric generally refers to materials having a dielectric constant greater than that of silicon dioxide (≅3.9), for practical purposes in very high density (sub-micron) memory applications, the dielectric constant should be at least 20-30 and, preferably, significantly higher in order to achieve the required capacitance. Examples of suitable capacitor dielectrics useful in the present invention include Ta₂O₅ and (Ba, Sr)TiO₃. The dielectric constants of films of these materials range from 30-40 and 1000-2000, respectively.

The material used for the electrode layer 170a should be compatible with the dielectric material so as not to interact with it to form a series resistance at the interface of the two layers. Generally, metals with a high work function (e.g. Ag, Cu, Au); refractory metals or their silicides (e.g. W, V, Pt, Pd, Ni, Ti, Mo, Ta, Co, or their silicides); nitrides (e.g. Ti and Al nitrides); and conductive oxides (e.g. RuO₂, IrO₂, SrRuO₃) are useful as electrode materials. However, in order to be compatible with present manufacturing techniques and to minimize the number of masks required, the top electrode 200a which is subsequently deposited, also serves as a barrier material to the plug 215. For the bottom electrode, it is believed that Pt, Pt Si₂, Ni, NiSi₂ and Cu would be preferred as they should offer good contact to the high dielectric constant film.

At step 1045, a dielectric layer 210 (Fig. 4) is formed over layers 170a, 180a, and 200a. The dielectric layer 210 is planarized using, for example, chemical mechanical polishing (CMP). Then, at step 1050, vias are formed in the dielectric layer 210 and, then at step 1055, conductive plugs 215 and 220 are formed in the vias. The plugs 215 and 220 and the vias are formed using the process described above for the plugs 140a, 140b and associated vias except that plug 215 is electrically coupled to storage capacitor 205a. In this case, the process for opening the vias in the dielectric layer 210 stops on the top electrode 200a. Accordingly, the material for the top electrode 200a is selected to be resistant to the process for etching the dielectric layer 210. In other words, dielectric layer 200a is an etch stop layer.

At step 1060, a storage capacitor 205b including conductive layer 170b, dielectric layer 180b, and conductive layer 200b is formed using the same processes to form layers 170a, 180a, and 200a except that the second capacitor is formed at a different elevation or level within the integrated circuit. In the exemplary embodiment, the storage capacitor 205b is formed in the next higher dielectric layer. Alternatively, the storage capacitor may be formed in other subsequent layers of the integrated circuit. In this way, the storage capacitors 205a, 205b of adjacent DRAM cells may be overlapped. This effectively reduces the cell size for a DRAM cell. In addition, the storage capacitors 205a, 205b may be formed asymmetrically above the plugs 145a, 220, respectively. The asymmetrical alignment is implemented to increase the amount that the storage capacitors may be overlapped.

Next, at step 1065, a dielectric layer 220 is formed on the storage capacitor. Then, subsequent conductive and dielectric layers (not shown) are formed to complete the integrated circuit.

Typical thickness' for the various layers of the device shown are from 8000Å to 10000Å for the dielectric layer 120, from 9000Å to 12000Å for the top dielectric 130, from 9000Å to 12000Å for the dielectric layer 210, from 9000Å to 12000Å for the dielectric 240, from 300Å to 500Å for the lower capacitor electrode layers 170a, 170b; from 100Å to 500Å for the high dielectric constant layers 180a, 180b, and from 300Å to 500Å for the top electrode 200a, 200b of the capacitor.

The various layers of the capacitors, i.e. the capacitor electrodes 170a, 170b and 200a, 200b and the high dielectric layer 180a,180b can be formed by conventional well known processing techniques. Typically, they will be formed by means of either sputtering or chemical vapor deposition, depending upon the material to be deposited. In general, sputtering offers low temperature processing which is usually preferred in the manufacture of integrated DRAM cells, provided the sputtered film quality is as good as the CVD deposited film for the material employed.

Fig. 6 is an alternative embodiment of the present invention. This device is formed using the same processes described above with regard to Figs. 1-4 except that the process includes an additional step for performing a blanket etch to remove a portion of the dielectric layers 130, 210 to expose a portion of the side walls of the plugs 145a and 220. This allows the storage capacitors to be formed on top of and on a portion of the sidewalls of the conductive plugs 145a, 220. As a result, the area of the storage capacitor is enlarged increasing the capacitance of the storage capacitor.

Although, the drawings and description above relate to two adjacent DRAM cells, the invention is not limited to adjacent DRAM cells or specific layers in the integrated circuit for the storage capacitors. For example, a third storage capacitor of a third DRAM cell may be formed on a different level than the storage capacitors of the DRAM cells shown in Figs. 5 and 6. Alternatively, every other DRAM cell may be formed in alternating layers of the IC.

## Claims

1. An integrated circuit comprising:
a first storage capacitor (e.g., 205b);
a second storage capacitor (e.g., 205a);
a first transistor electrically coupled to the first storage capacitor (e.g., 205b); and
a second transistor electrically coupled to the second storage capacitor (e.g., 205a);
wherein the first storage capacitor (e.g., 205b) is positioned above the second storage capacitor.

2. The integrated circuit of claim 1 further comprising:
a first layer (e.g., 240); and
a second layer (e.g., 210) different from the first layer (e.g., 240);
wherein the first storage capacitor (e.g., 205b) is formed in the first layer (e.g., 240) and the second storage capacitor (e.g., 205a) is formed in the second layer (e.g., 240).

3. The integrated circuit of claim 1 wherein the second storage capacitor (e.g., 205a) overlaps the first storage capacitor (e.g., 205b).

4. The integrated circuit of claim 1 wherein the first transistor and the first storage capacitor (e.g., 205b) form a first DRAM cell and the second transistor and the second storage capacitor form a second DRAM cell.

5. The integrated circuit of claim 4 wherein the first DRAM cell is adjacent to the second DRAM cell.

6. The integrated circuit of claim 1 further comprising a first interlevel interconnect (e.g., 220) and a second interlevel interconnect (e.g., 145a) wherein the first storage capacitor (e.g., 205b) is formed above and in asymmetrical relationship to the first interlevel interconnect (e.g., 220).

7. The integrated circuit of claim 6 wherein the second storage capacitor (e.g., 205a) is formed above and in asymmetrical relationship to the second interlevel interconnect (e.g., 145a).

8. An integrated circuit comprising:
a first memory cell having a first storage capacitor (e.g., 205b);
a second memory cell having a second storage capacitor (e.g., 205a);
wherein the first storage capacitor (e.g., 205b) is formed above the second storage capacitor (e.g., 205a).

9. A method for forming an integrated circuit comprising:
forming a first storage capacitor (e.g., 205b);
forming a second storage capacitor (e.g., 205a) positioned above the first storage capacitor (e.g., 205b);
forming a first transistor electrically coupled to the first storage capacitor (e.g., 205b); and
forming a second transistor electrically coupled to the second storage capacitor (e.g., 205a).

10. The method of claim 9 further comprising:
forming a first layer (e.g., 240) including the first storage capacitor (e.g., 205b); and
forming a second layer (e.g., 210) including the second storage capacitor (e.g., 205a), the second layer (e.g., 210) different from the first layer (e.g., 240).

11. The method of claim 9 further comprising forming the first storage capacitor (e.g., 205b) to overlap the second storage capacitor (e.g., 205a).

12. The method of claim 9 wherein the first transistor and the first storage capacitor (e.g., 205b) form a first DRAM cell and the second transistor and the second storage capacitor (e.g., 205a) form a second DRAM cell.

13. The method of claim 2 wherein the first DRAM cell is adjacent to the second DRAM cell.

14. The method of claim 9 further comprising:
forming a first interlevel interconnect (e.g., 220)
forming a second interlevel interconnect (e.g., 145a); and
forming the first storage capacitor (e.g., 205b) above and in asymmetrical relationship to the first interlevel interconnect (e.g., 220).

15. The method of claim 14 wherein the second storage capacitor (e.g., 205a) is formed above and in asymmetrical relationship to the second interlevel interconnect (e.g., 145a).
